# EUROPEAN PATENT APPLICATION

(11) **EP 0 893 835 A2**
(43) Date of publication of application: **27.01.1999**
(21) Application number: 98401808.5
(22) Date of filing: 17.07.1998
(51) Int. Cl.: H01L 39/14

(54) **Superconducting field effect device having a superconducting channel and method for manufacturing the same**

(30) Priority: 22.07.1997 JP 211300/97
(71) Applicant: SUMITOMO ELECTRIC INDUSTRIES, LIMITED, Osaka 541 (JP)
(72) Inventor: Nakamura, Takao, Konohana-ku, Osaka (JP); Iiyama, Michitomo, Konohana-ku, Osaka (JP); Inada, Hiroshi, Konohana-ku, Osaka (JP)
(74) Representative: Ballot, Paul Denis Jacques

(57) **Abstract**

A FET type superconducting device comprises a substrate having a principal surface, a thin superconducting channel formed of a c-axis orientated film of an oxide superconductor over the principal surface of the substrate, a superconducting source and a superconducting drain formed of an oxide superconductor over the principal surface of the substrate at the both ends of the superconducting channel which connects the superconducting source region and the superconducting drain region, so that superconducting current can flow through the superconducting channel between the superconducting source region and the superconducting drain region and a gate electrode on a gate insulator disposed on the superconducting channel for controlling the superconducting current flowing through the superconducting channel by a signal voltage applied to the gate electrode; wherein at least a portion of the gate electrode adjacent to the gate insulator is formed of an oxide superconductor same as that of the superconducting channel.

## Description

### Background of the Invention

### Field of the invention

The present invention relates to a superconducting field effect device and method for manufacturing it. More specifically the present invention relates to a field effect transistor type superconducting device comprising a superconducting channel of oxide superconductor, which has more excellent characteristics than the conventional one.

### Description of related art

Devices which utilize superconducting phenomena operate rapidly with low power consumption so that they have higher performance than conventional semiconductor devices. Particularly, by using an oxide superconductor material which has been recently advanced in study, it is possible to produce a superconducting device which operates at relatively high temperature.

One of the most important three-terminal superconducting devices is a field effect transistor type superconducting device (abbreviated as super-FET hereinafter) having a channel of a superconductor formed between a source and a drain. In this superconducting device, a current flowing through the superconducting channel is controlled by a signal voltage applied to a gate formed above the superconducting channel.

The super-FET mentioned above is a voltage controlled device which is capable of isolating output signals from input ones and of having a well defined gain. In addition, it has a large current capability.

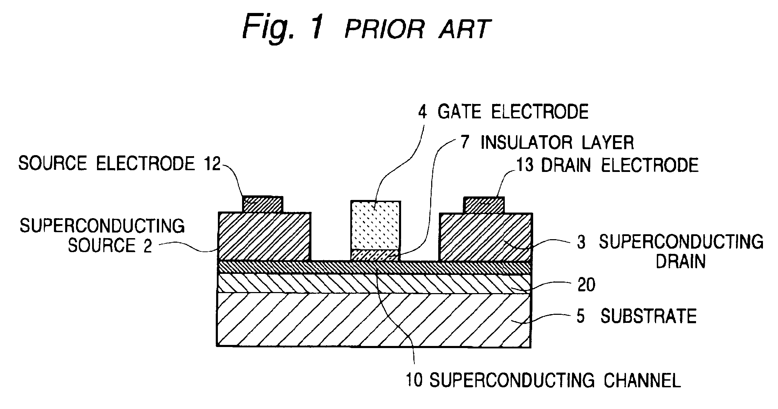

Referring to Figure 1, a typical super-FET utilizing an oxide superconductor will be explained. Figure 1 shows a sectional view of a super-FET which is similar to the one described in the published European Patent Application No. EP-A-0 533 519.

The super-FET shown in Figure 1 comprises a substrate 5 of, for example, SrTiO₃, a buffer layer 20 of an oxide, for example, Pr₁Ba₂Cu₃O_{7-y} disposed on the substrate 5, a superconducting channel 10 of an oxide superconductor, for example, Y₁Ba₂Cu₃O₇₋ₓ disposed on the buffer layer 20, a superconducting source region 2 and a superconducting drain region 3 of Y₁Ba₂Cu₃O₇₋ₓ disposed at each end of the superconducting channel 10. The super-FET further comprises a gate electrode 4 on a gate insulator 7 disposed on the superconducting channel 10, a source electrode 12 and a drain electrode 13 disposed each on the superconducting source region 2 and superconducting drain region 3.

The superconducting source region 2 and superconducting drain region 3 can be formed of an oxide superconductor different from that of the superconducting channel 10. The gate electrode 4, source electrode 12 and drain electrode 13 can be formed of a noble metal such as Ag, Pt, Au.

In the super-FET, superconducting current flowing through the superconducting channel 10 is controlled by a signal voltage applied to the gate electrode 4. The Y₁Ba₂Cu₃O₇₋ₓ oxide superconductor has a carrier density of 10²⁰-10²¹/cm³, so that both of the superconducting channel and the gate insulator should have an extremely thin thickness to obtain a complete ON/OFF operation by a signal voltage of a few volts, which is usually used for CMOS semiconductor devices, applied to the gate electrode 4. For example, the superconducting channel should have a thickness of five nanometers or less and the gate insulating layer should have a thickness of ten to fifteen nanometers or more to prevent a tunnel current, but it should be as thin as possible.

For excellent properties of the super-FET, the thin superconducting channel should be formed of an oxide superconductor film having good characteristics and high crystallinity without any grain boundary which may form an unnecessary Josephson junction. In order to realize this thin superconducting channel, the above super-FET comprises a buffer layer 20 of Pr₁Ba₂Cu₃O_{7-y} oxide having a crystal structure equal to that of Y₁Ba₂Cu₃O₇₋ₓ oxide superconductor and lattice parameters similar to those of Y₁Ba₂Cu₃O₇₋ₓ oxide superconductor is formed on the substrate 5 and the oxide superconductor film of the superconducting channel 10 is deposited on the buffer layer 20.

The buffer layer prevents interdiffusion between the substrate and the superconducting channel and cancels inconsistencies of lattice parameters. Therefore, an oxide superconductor film well grows second dimensionally on the buffer layer.

However, the super-FET has a layered gate structure in which an oxide superconductor film, an insulator or a dielectric film and a metal are stacked in the named order. Due to this layered gate structure, asymmetry and dependence on the kind of the metal are appeared in the current-voltage characteristics of the gate and the electric field dependence of the dielectric constant of the insulator, as shown in Applied Physics Letter No. 60 (1990) pp. 1744, Applied Physics No. 75 (1994) pp.5295, Japanese Journal of Applied Physics No. 34 (1995) pp. 1906. These asymmetry and dependence Limit the range of the gate voltage and cause the dependence on polarity of the gate voltagc in the modulation characteristics, which results instability of the performance of the super-FET.

### Summary of the Invention

Accordingly, it is an object of the present invention to provide a novel super-FET having a superconducting channel of an oxide superconductor film, which have overcome the above mentioned defects of the conventional ones.

Another object of the present invention to provide a method for manufacturing the above novel super-FET.

The above and other objects of the present invention are achieved in accordance with the present invention by a superconducting device;
comprising:
a substrate having a principal surface;
a thin superconducting channel formed of a c-axis oricntated film of an oxide superconductor over the principal surface of the substrate;
a superconducting source and a superconducting drain formed of an oxide superconductor over the principal surface of the substrate at the both ends of the superconducting channel which connects the superconducting source region and the superconducting drain region, so that superconducting current can flow through the superconducting channel between the superconducting source region and the superconducting drain region; and
a gate electrode on a gate insulator disposed on the superconducting channel for controlling the superconducting current flowing through the superconducting channel by a signal voltage applied to the gate electrode; wherein at least a portion of the gate electrode adjacent to the gate insulator is formed of an oxide superconductor same as that of the superconducting channel.

According to one embodiment of the present invention, an insulator film of the gate insulator is stacked all over the c-axis orientated film of the oxide superconductor, the superconducting source and the superconducting drain penetrate the insulator film and oxide superconductor film and are formed directly on the principal surface of the substrate so that the superconducting source and the superconducting drain contact with the superconducting channel on surfaces parallel to the c-axis.

According to one embodiment of the present invention, a flanged superconducting source electrode and superconducting drain electrode are disposed on the superconducting source and the superconducting drain. A metal source electrode and drain electrode are preferably disposed on the superconducting source electrode and superconducting drain electrode. It is also preferable that metal gate electrode is disposed on the superconducting portion of the gate electrode.

In a preferred embodiment, the superconducting source region and superconducting drain region are formed of high-T_{c} (high critical temperature) oxide superconductor, particularly, formed of a high-T_{c} copper-oxide type compound oxide superconductor for example a Y-Ba-Cu-O compound oxide superconductor material, a Bi-Sr-Ca-Cu-O compound oxide superconductor material, and a Tl-Ba-Ca-Cu-O compound oxide superconductor material.

In addition, the substrate can be formed of an insulating substrate, preferably an oxide single crystalline substrate such as MgO, SrTiO₃, YSZ, etc. These substrate materials are very effective in forming or growing a crystalline film having a well defined crystalline orientation.

However, in one preferred embodiment, the super-FET can be formed on a substrate of a semiconductor material, if an appropriate insulating buffer layer is deposited thereon. For example, the buffer layer on the semiconductor substrate can be formed of a double-layer coating formed of a MgAl₂O₄ layer and a BaTiO₃ layer if silicon is used as a substrate.

According to another aspect of the present invention, there is provided a method for manufacturing a superconducting device comprising:
a substrate having a principal surface;
a thin superconducting channel formed of an oxide superconductor layer on the principal surface of the substrate;
a superconducting source region and a superconducting drain region formed of an oxide superconductor on the principal surface of the substrate at the both ends of the superconducting channel which connects the superconducting source region and the superconducting drain region, so that superconducting current can flow through the superconducting channel between the superconducting source region and the superconducting drain region; and
a gate electrode on a gate insulator disposed on the superconducting channel for controlling the superconducting current flowing through the superconducting channel by a signal voltage applied to the gate electrode;
comprising the steps of:
depositing an oxide superconductor layer on the principal surface of the substrate;
depositing an insulator layer on the oxide superconductor layer;
etching the insulator layer and the oxide superconductor layer so as to form contact holes apart from each other, which reach the principal surface of the substrate;
depositing an oxide superconductor layer so as to form a superconducting source region and a superconducting drain region in the contact holes, which have a superconducting source electrode and a superconducting drain electrode at their tops, and so as to form a superconducting gate electrode simultaneously; and
forming a metal source electrode, a metal drain electrode and a metal gate electrode on the superconducting source electrode, the superconducting drain electrode and the superconducting gate electrode.

The above and other objects, features and advantages of the present invention will be apparent from the following description of preferred embodiments of the invention with reference to the accompanying drawings.

### Brief Description of the Drawings

Figure 1 is a diagrammatic sectional view of a typical super-FET;
Figures 2A to 2F are diagrammatic sectional views for illustrating an embodiment of the process for manufacturing the super-FET in accordance with the present invention;
Figure 3A shows resistance-temperature characteristics of the superconducting channels of the super-FETs in accordance with the present invention;
Figure 3B shows current-voltage characteristics of the gates of the super-FETs in accordance with the present invention;
Figures 4A to 4C show temperature dependence of the modulation characteristics of the super-FET in accordance with the present invention;
Figure 5 shows transconductance of the super-FET in accordance with the present invention;
Figure 6 shows resistance-temperature characteristics of the superconducting channel of another super-FET in accordance with the present invention;
Figure 7 shows the modulation characteristics of the super-FET of Figure 6; and
Figure 8 shows the relation between critical temperature and thickness of the superconducting channels of the super-FETs in accordance with the present invention.

### Description of the Preferred embodiments

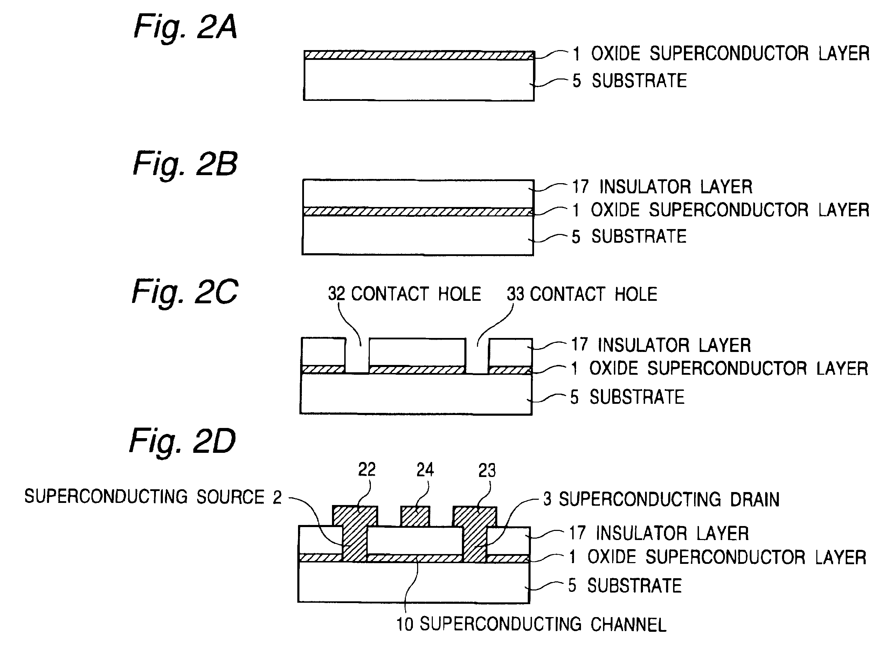

Referring to Figures 2A to 2F, a process for manufacturing the super-FET in accordance with the present invention will be described.

On a SrTiO₃ (100) single crystalline substrate 5, a thin c-axis orientated Y₁Ba₂Cu₃O₇₋ₓ oxide superconductor film 1 was deposited by a reactive co-evaporation, as shown in Figure 2A. The c-axis orientated Y₁Ba₂Cu₃O₇₋ₓ oxide superconductor film 1 was formed of a Y₁Ba₂Cu₃O₇₋ₓ oxide superconductor crystal having c-axes perpendicular to the substrate. The Y₁Ba₂Cu₃O₇₋ₓ oxide superconductor film 1 may also be prepared by an MBE (Molecular Beam Epitaxy). A condition of forming the Y₁Ba₂Cu₃O₇₋ₓ oxide superconductor film 1 by a reactive co-evaporation is as follows:

| | |
|---|---|
| Substrate temperature | 690 °C |
| Pressure | 3.999 × 10⁻³ Pa (3 × 10⁻⁵ Torr) |
| (near the substrate; O₂ including 70 vol. % O₃ or more) | |
| Evaporation source and Y: | 1220 °C |
| its crucible temperature Ba: | 620 °C |
| Cu: | 1000 °C |
| Deposition rate | 0.3 nm/min. |

The substrate can be formed of an insulating substrate, preferably an oxide single crystalline substrate such as MgO (100), YSZ, as well as SrTiO₃ (100). These substrate materials are very effective in forming or growing a crystalline film having a well defined crystalline orientation.

However, the super-FET can be formed on a substrate of a semiconductor material, if an appropriate insulating buffer layer is deposited thereon. For example, the buffer layer on the semiconductor substrate can be formed of a double-layer coating formed of a MgAl₂O₄ layer and a BaTiO₃ layer, of CeO₂ layer and of YSZ layer if silicon is used as a substrate.

In case of using a SrTiO₃ (100) substrate, it is preferable to clean a surface of the substrate by treatment using HF buffer solution.

Then, as shown in Figure 2B, an insulator layer 17 of SrTiO₃ was formed on the Y₁Ba₂Cu₃O₇₋ₓ oxide superconductor film 1 by pulsed laser deposition The insulator layer 17 will constitute a gate insulator which should have a thickness of 10 nanometers or more so as to prevent tunnel current. However, if the gate insulator has a too large thickness, higher signal voltages are required to modulate and control superconducting current flowing through the superconducting channel. Therefore, the insulator layer 17 should have a thickness of 4000 nanometers or less. A condition of forming the SrTiO₃ insulator layer 17 by pulsed laser deposition is as follows:

| | |
|---|---|
| Substrate temperature | 600 °C |
| Pressure | 3.999 Pa (0.03 Torr; O₂) |
| Laser energy density | 2 J/cm² |
| Laser pulse rate | 3 Hz |
| Deposition rate | 30 nm/min. |

The insulator layer 17 can be formed of Bi₄Ti₃O₁₂, BaₓSr₁₋ₓTiO₃ (0 ≤ x ≤ 1), PZT (Pb(Zr, Ti)O₃), and CeO₂. The substrate temperature of 600 °C prevented mutual diffusion of constituent elements between the oxide superconductor film 1 and substrate 5 and between the insulator layer 17 and oxide superconductor film 1 so that the interfaces were clearly formed.

Thereafter, forming a mask by using photoresist, the insulator layer 17 and oxide superconductor film 1 were etched by ion milling using Ar ions so as to form contact holes 32 and 33 that reached the substrate 5, as shown in Figure 2C. The contact holes 32 and 33 had a size of 10 x 10 µm² and located 10 µm apart.

Since the contact holes 32 and 33 were formed to reach the substrate 5, fine control of etching depth was unnecessary. Therefore, this process was easy to conduct.

As shown in Figure 2D, a superconducting source 2, superconducting drain 3 and a superconducting gate electrode 24 were formed in the contact holes 32 and 33 and on a center portion of the insulator layer 17 between the contact holes 32 and 33 by depositing Y₁Ba₂Cu₃O₇₋ₓ oxide superconductor film by pulsed laser deposition. The top 22 of the superconducting source 2 and the top 23 of the superconducting drain 3 were flanged and patterned so as to form superconducting electrodes.

The condition for forming the Y₁Ba₂Cu₃O₇₋ₓ oxide superconductor film by pulsed laser deposition was equal to that of SrTiO₃ insulator layer 17 so that mutual diffusions between the layers did not occur.

A portion of the Y₁Ba₂Cu₃O₇₋ₓ oxide superconductor film 1 just under the superconducting gate electrode 24 formed superconducting channel 10.

Since the superconducting source electrode 22, superconducting drain electrode 23 and superconducting gate electrode 24 were simultaneously formed, this step contributed to simplify the process for manufacturing the super-FET.

While the Y₁Ba₂Cu₃O₇₋ₓ oxide superconductor film was deposited, oxygen penetrated into the thin oxide superconductor film 1, which improved the superconducting properties and crystallinity of the oxide superconductor film 1. This is because the Y₁Ba₂Cu₃O_{7-X} oxide superconductor film was deposited under an oxygen rich atmosphere and side surfaces parallel to the c-axis of the oxide superconductor film 1 were exposed. The oxide superconductor has a diffusion coefficient in the direction perpendicular to its c-axis some ten thousands larger than those of other directions. Therefore, oxygen efficiently penetrated and diffused into the oxide superconductor film 1 through its side surfaces parallel to its c-axis.

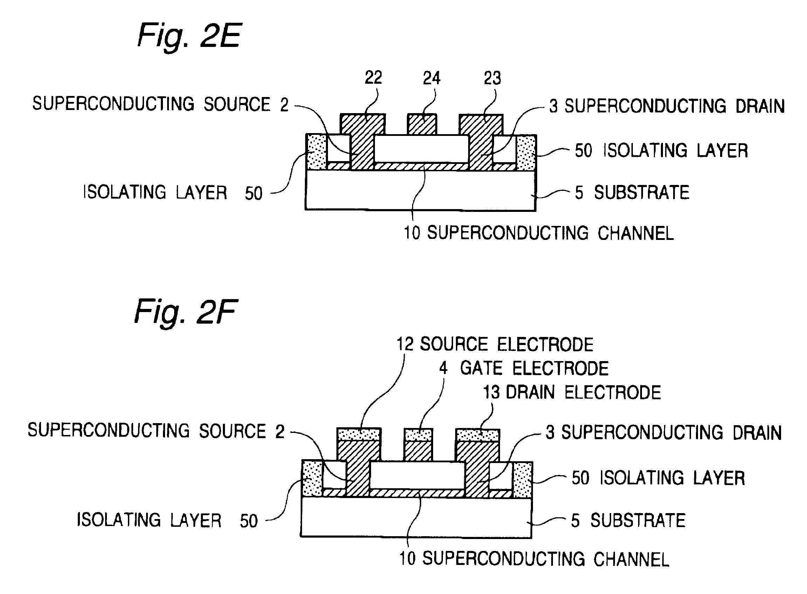

Then, as shown in Figure 2E, both ends of the insulator layer 17 were removed and isolating layers 50 were formed of CeO₂ by depositing CeO₂ layer by pulsed laser deposition at the room temperature and removing a portion of the CeO₂ layer on the device by lift-off process. The isolating layers electrically separated the devices formed on a common substrate from each other. For this purpose, the isolating layer is preferably formed of a material through which little leakage current flows and which can be deposited at a low temperature to prevent mutual diffusion between the layers of the device. CaF₂ and SiO₂ can also be used for the isolating layer, however, CeO₂ is the most preferable in view of the above condition.

Finally, as shown in Figure 2F, a metal source electrode 12, a drain electrode 13 and a gate electrode 4 of Ag were formed on each of the superconducting source electrode 22, superconducting drain electrode 23 and superconducting gate electrode 24 by vacuum deposition. With this, the super-FET in accordance with the present invention was completed.

Properties of super-FETs in accordance with the present invention manufactured as mentioned above were measured Each four of the super-FETs were formed on a common SrTiO₃ (100) substrate (8 x 9 mm²) and each one super-FET had a superconducting channel 10 of a Y₁Ba₂Cu₃O₇₋ₓ oxide superconductor film having a thickness of 5 nm, an insulator layer 17 of SrTiO₃ having a thickness of 200 nm, a superconducting source electrode 22, superconducting drain electrode 23 and superconducting gate electrode 24 of a Y₁Ba₂Cu₃O₇₋ₓ oxide superconductor film having a thickness of 100 nm. The gate had a length of 40 µm and a width of 100 µm.

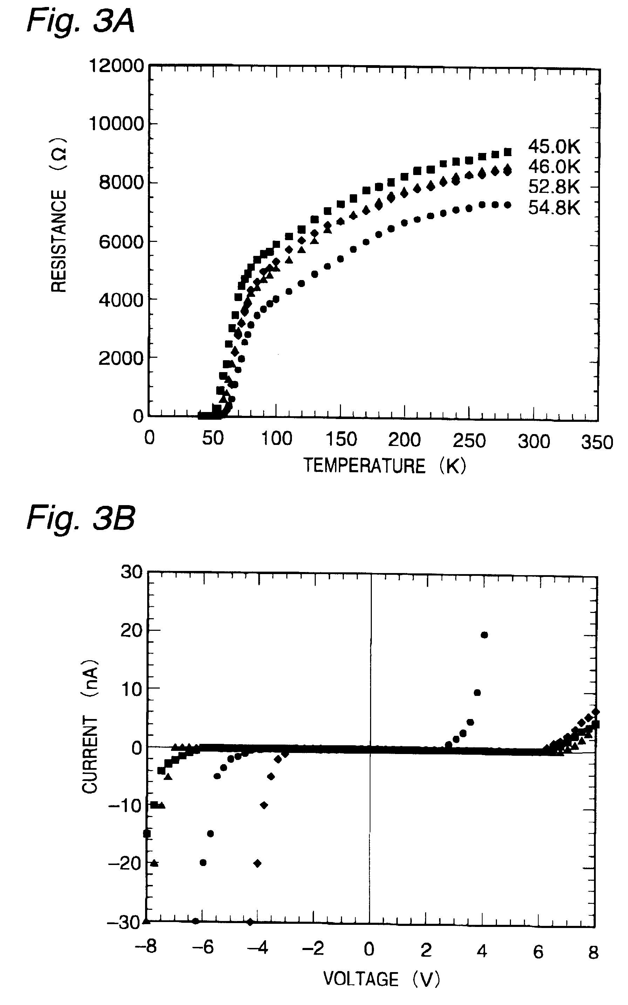

Figure 3A shows resistance-temperature characteristics of the superconducting channels of the super-FETs in accordance with the present invention. As shown in Figure 3A, the superconducting channels of the super-FETs in accordance with the present invention have a critical temperature of 54.8 K at the highest, which is the highest of all the super-FETs of this type having no buffer layer between the substrate and the superconducting channel reported to date.

Figure 3B shows current-voltage characteristics of the gates of the super-FETs in accordance with the present invention. As shown in Figure 3B, the super-FETs in accordance with the present invention have symmetrical current-voltage characteristics of the gates since they have a symmetric layered structure of Y₁Ba₂Cu₃O₇₋ₓ/SrTiO₃/Y₁Ba₂Cu₃O₇₋ₓ. In particular, they have twice larger breakdown voltages in the negative side compared to the conventional super-FET having a gate electrode formed only of a metal.

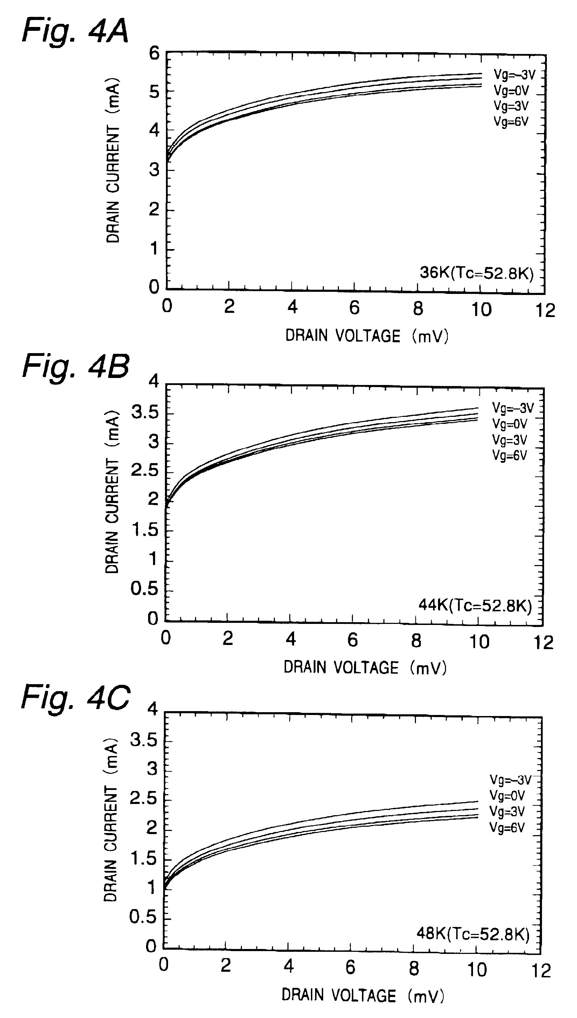

Figures 4A to 4C show temperature dependence of the modulation characteristics of the super-FET in accordance with the present invention. As shown in Figures 4A to 4C, the super-FET in accordance with the present invention has larger magnitude, particularly, of the depletion operation than that of the conventional super-FET, which is advantageous for applications to practical electronic circuits.

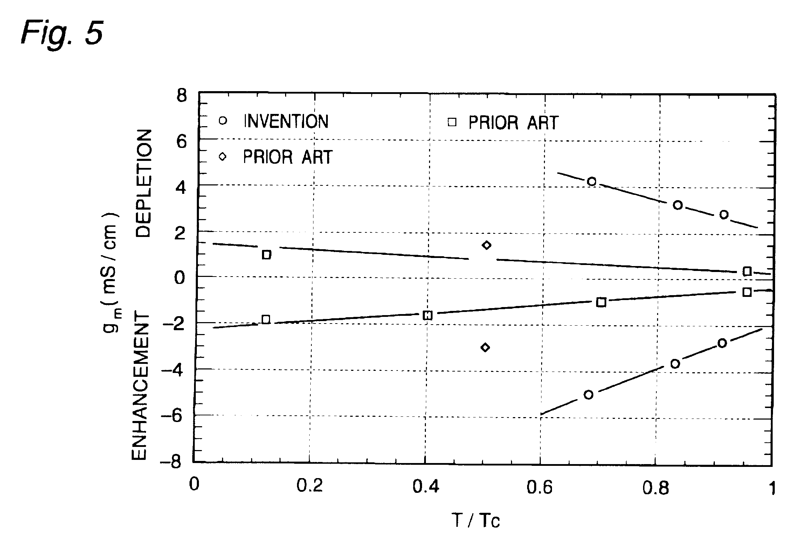

Figure 5 shows transconductance of the super-FET in accordance with the present invention. As shown in Figure 5, the super-FET in accordance with the present invention has higher transconductance.

The super-FETs formed on the common substrate can be connected properly so as to simultaneously function as a superconducting device having a large current capability.

Properties of other super-FETs in accordance with the present invention having a 4 nm thick superconducting channel were measured. The other sizes of the super-FETs were equal to those of the super-FETs mentioned above.

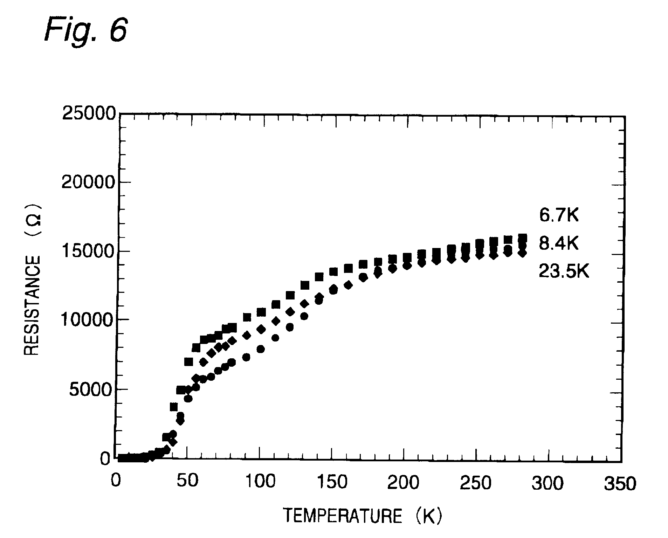

Figure 6 shows resistance-temperature characteristics of the superconducting channel of the super-FETs in accordance with the present invention. As shown in Figure 6, the superconducting channels having a thickness of 4 nm of the super-FETs in accordance with the present invention have a critical temperature of 23.8 K at the highest.

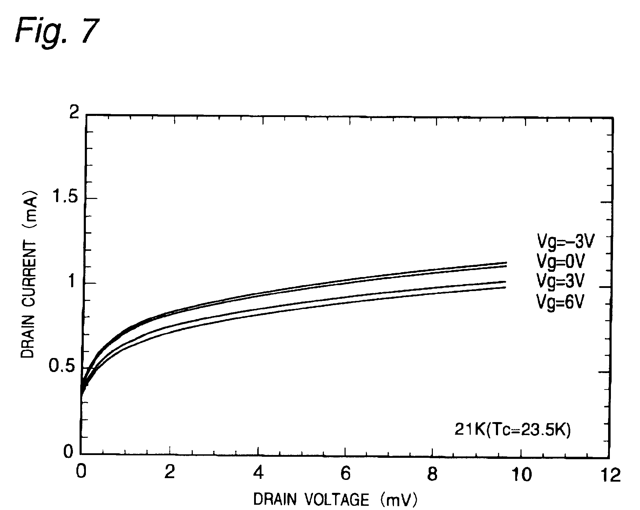

Figure 7 shows the modulation characteristics of the super-FETs having 4 nm thick superconducting channels. As shown in Figure 7, the drain current was suppressed by -12.5 % by applying gate voltage, which is one of the largest values in the depletion direction.

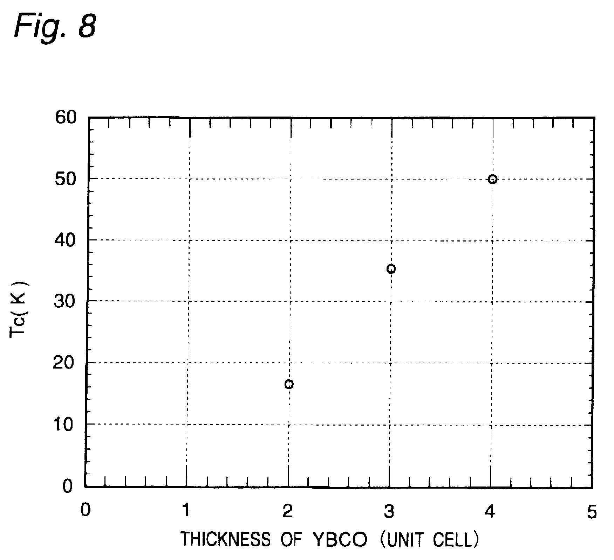

Figure 8 shows the relation between critical temperature and thickness of the superconducting channels of the super-FETs in accordance with the present invention. In Figure 8, the thickness of the superconducting channels are shown by the number of unit cells of the oxide superconductor. The superconducting channels of the super-FETs in accordance with the present invention showed superconductivity even if it had a thickness of 2 unit cells of the oxide superconductor. This super-FET having a superconducting channel of 2 unit cells thick yielded 33 % of modulation.

This super-FET had a SrTiO₃ (100) substrate so that the superconducting channel was hetero-epitaxially grown. Thus, the unit cell of the oxide superconductor adjacent to the substrate had distorted lattice so that it did not have superconductivity. In this super-FET, it is considered that a superconducting channel substantially having a thickness of one unit cell had superconductivity, which proves advantages of the present invention.

As explained above, according to the invention, a novel super-FET is provided. The super-FET of the present invention has a gate structure of oxide superconductor/insulator/oxide superconductor, which contributes symmetrical current-voltage characteristics of its gate, relaxation of the limitation of the gate voltage and cancellation of the dependence on polarity of the gate voltage in the modulation characteristics so as to improve performance of the super-FET.

In the above mentioned embodiment, the oxide superconductor film can be formed of not only the Y-Ba-Cu-O compound oxide superconductor material, but also a high-T_{c} (high critical temperature) oxide superconductor material, particularly a high-T_{c} copper-oxide type compound oxide superconductor material, for example a Bi-Sr-Ca-Cu-O compound oxide superconductor material, and a Tl-Ba-Ca-Cu-O compound oxide superconductor material.

The invention has thus been shown and described with reference to the specific embodiments. However, it should be noted that the present invention is in no way limited to the details of the illustrated structures but converts and modifications may be made within the scope of the appended claims.

## Claims

1. A superconducting device;
comprising:
a substrate having a principal surface;
a thin superconducting channel formed of a c-axis orientated film of an oxide superconductor over the principal surface of the substrate;
a superconducting source and a superconducting drain formed of an oxide superconductor over the principal surface of the substrate at the both ends of the superconducting channel which connects the superconducting source region and the superconducting drain region, so that superconducting current can flow through the superconducting channel between the superconducting source region and the superconducting drain region; and
a gate electrode on a gate insulator disposed on the superconducting channel for controlling the superconducting current flowing through the superconducting channel by a signal voltage applied to the gate electrode; wherein at least a portion of the gate electrode adjacent to the gate insulator is formed of an oxide superconductor same as that of the superconducting channel.

2. A superconducting device as claimed in Claim 1; wherein an insulator film of the gate insulator is stacked all over the *c*-axis orientated film of the oxide superconductor, the superconducting source and the superconducting drain penetrate the insulator film and oxide superconductor film and are formed directly on the principal surface of the substrate so that the superconducting source and the superconducting drain contact with the superconducting channel on surfaces parallel to the *c*-axis.

3. A superconducting device as claimed in Claim 1; wherein a flanged superconducting source electrode and superconducting drain electrode are disposed on the superconducting source and the superconducting drain.

4. A superconducting device as claimed in Claim 3; wherein a metal source electrode and drain electrode are disposed on the superconducting source electrode and superconducting drain electrode.

5. A superconducting device as claimed in Claim 1; wherein a metal gate electrode is disposed on the superconducting portion of the gate electrode.

6. A superconducting device as claimed in Claim 1; wherein the superconducting source region and superconducting drain region comprise high-T_{c} (high critical temperature) oxide superconductor, particularly, formed of a high-T_{c} copper-oxide type compound oxide superconductor.

7. A superconducting device as claimed in Claim 6; wherein the oxide superconductor is formed of oxide superconductor material selected from the group consisting of a Y-Ba-Cu-O compound oxide superconductor material, a Bi-Sr-Ca-Cu-O compound oxide superconductor material, and a Tl-Ba-Ca-Cu-O compound oxide superconductor material.

8. A superconducting device as claimed in Claim 1; wherein the substrate is formed of a material selected from the group consisting of a MgO (100) substrate, a SrTiO₃ (100) substrate, a YSZ substrate and a semiconductor substrate having a insulating buffer layer on its surface.

9. A method for manufacturing a superconducting device comprising:
a substrate having a principal surface;
a thin superconducting channel formed of an oxide superconductor layer on the principal surface of the substrate;
a superconducting source region and a superconducting drain region formed of an oxide superconductor on the principal surface of the substrate at the both ends of the superconducting channel which connects the superconducting source region and the superconducting drain region, so that superconducting current can flow through the superconducting channel between the superconducting source region and the superconducting drain region; and
a gate electrode on a gate insulator disposed on the superconducting channel for controlling the superconducting current flowing through the superconducting channel by a signal voltage applied to the gate electrode;
comprising the steps of:
depositing an oxide superconductor layer on the principal surface of the substrate;
depositing an insulator layer on the oxide superconductor layer;
etching the insulator layer and the oxide superconductor layer so as to form contact holes apart from each other, which reach the principal surface of the substrate;
depositing an oxide superconductor layer so as to form a superconducting source region and a superconducting drain region in the contact holes, which have a superconducting source electrode and a superconducting drain electrode at their tops, and so as to form a superconducting gate electrode simultaneously; and
forming a metal source electrode, a metal drain electrode and a metal gate electrode on the superconducting source electrode, the superconducting drain electrode and the superconducting gate electrode.
